(19) Europäisches Patentamt
European Patent Office
Office européen des brevets

(11) **EP 0 967 628 A2**

## (12) EUROPÄISCHE PATENTANMELDUNG

(43) Veröffentlichungstag:
**29.12.1999 Patentblatt 1999/52**

(51) Int. Cl.$^6$: **H01J 27/18**

(21) Anmeldenummer: **97117431.3**

(22) Anmeldetag: **08.10.1997**

(84) Benannte Vertragsstaaten:
**AT BE CH DE DK ES FI FR GB GR IE IT LI LU MC NL PT SE**

(30) Priorität: **08.10.1996 DE 19641439**

(71) Anmelder: **Ehret, H.-P.**
**76344 Eggenstein-Leopoldshafen (DE)**

(72) Erfinder: **Ehret, H.-P.**
**76344 Eggenstein-Leopoldshafen (DE)**

(54) **ECR-Ionenquelle 2,45GHz**

(57)    Eine ECR-IQ, bestehend aus dem Vakuumeinschluß (2), des µ-Wellenresonators cavity (1), dem Hohlleiter (14) und dem Einkoppelschlitz (15), Fig. 1, sowie dem Strahlführungssystem, Fig. 2 und Fig. 3.

Für bestimmte Prozesse ist es vorteilhaft, den Vakuumeinschluß (2), die cavity (1), den Hohlleiter (14) und den Einkoppelschlitz (15), Fig. 1, zu vereinen.

Weiter den Flanschen (4 u. 5) mit dem Gaseinlaß (10), dem Targethalter und Target (12 u. 13) und dem Laserfenster (11)zur Einleitung der Laserenergie mit Zielpunkt Target (13), Fig. 1.

Flansch (5) mit Plasmaelektrode (7), Fig. 1, oder Plasmagitter (17), Fig. 3.

Der Magnetfeldeinschluß (3 u. 6), Fig. 1, sind radial und axial einstellbar.

Die ECR-IQ ist zur Ableitung der Betriebswärme mit einer Kühlgaszirkulation (16) Fig.1u.7 ausgestattet.

Flansch (5) und Plasmaelektrode (7), Fig. 1, folgen in den Isolatoren (8), Fig. 2, die Ionenstrahl-Steuerelemente (9 u. 18), Fig. 2, und (19. u. 17), Fig. 3. Die Plasmaelektrode (7), Fig. 1 u. Fig. 2, ist Bestandteil der Ionenstrahl-Steuerelemente. Die Reihenfolge wird durch den Prozeß bestimmt.

Eine weitere Anwendung/Aufgabe der Erfindung ist die Erzeugung hochgeladener Ionen unterhalb einer Betriebsfrequenz von 7 G Hz.

Die erfindungsgemäße ECR-IQ 2,45 G Hz erzeugt einen Plasmastrahl/Ionenstrahl unter Ausschaltung des magnetischen Längsfeldes (6), Fig. 1,u.(3o)Fig.9u.11.

Fig. 4 zeigt eine vorteilhafte Ausgestaltung der erfindungsgemäßen Vorrichtung,weitere Ausgestaltung gemäß Fig.9,1o,11u.12.

FIG.3

EP 0 967 628 A2

## Beschreibung

ECR-IQ wurden um 1970 in Grenoble entwickelt. Ihre Entwicklung und Anwendung war für große Beschleunigungsanlagen konzipiert; Die Kosten einer ECR-IQ hatte und hat die Größenordnung von 1 bis über 1o Mio. US. Angesichts dieser Größenordnungen wurde ihre Anwendung in Labors, Technik, Oberflächentechnik, Medizin, z.B. bei Humanimplantation der Orthopädie und der curativen Herztherapie, der Raumfahrt und weiteren Anwendungsgebieten erst garnicht angedacht. Die Kosten einer ECR-IQ sind auch heute noch sehr hoch und ihre Bedienung meist noch die hohe Kunst der Experimentalphysik.

Die erfindungsgemäße ECR-IQ 2,45 G Hz beendet die Hochpreis- und Höchsttechnologie-Aera und macht die ECR-IQ zu einem Technologie- und Laborgerät mit einem, noch nicht abgrenzbaren Anwendungsspektrum und Serienherstellung. Die 10 G Hz-ECR-Anlagen kann sie nicht ersetzen.

Literatur:     Dr. Hitze et al., KIV-Report 996, Rijksuniversiteit Groningen, Seite 91-96.

ECR-IQ haben den Vorteil einer hohen Standzeit, sind verschleißfrei. Ihr Nachteil: die hohen Kosten der Hochfrequenzsender. Größenordnung: 1oo.ooo,--DM und höher. Der Aufwand für den magnetischen Plasmaeinschluß korrespondiert mit der Frequenz. Konfrontiert mit diesen Kosten wurde die weitere Anwendung von ECR-IQ nicht weiterverfolgt. Die Implantation von z.B. Phosphor der Masse 32 oder Berylium, mittels einer ECR-IQ, wesentlich kostengünstiger als eine Sputter-Ionenquelle, wurde als nicht realisierbar eingestuft. Wird heute im Labormaßstab mittels einer Kopie der erfindungsgemäßen ECR-IQ realisiert.

Die erfindungsgemäße ECR-IQ löst dieses Problem mittels einer vorteilhaften konstruktiven Verknüpfung von Vakuumeinschluß, des dem Vakuumeinschluß und der Frequenz zugeordneten magnetischem Einschlußes, der Ankoppelung einer Hochfrequenzanlage 2,45 G Hz (dies bedeutet keine Einschränkung auf diese Frequenz), wenigstens einer Laserstrahlanlage und der dazugehörenden Targets. Die Targets sind innerhalb des Vakuumeinschlußes so positioniert, daß durch die Beaufschlagung der Targets durch den Laserstrahl, das Targetmaterial verdampft und hochgradig ionisiert an das Primärplasma übergehen wird. Das Plasma ist dotiert. Wenigstens einer Gaszufuhranlage, zur Erzeugung eines prozesskonformen Mono- oder Mixplasmas. Das Mixplasma kann aus einer Vielzahl von Gasen quantitativ präzise eingestellt werden. Über das Extraction- und Strahlführungssystem werden die Ionen in Richtung der zu beschichtenden Fläche beschleunigt.

Die vorteilhafte Wirkung einer Beschichtung und/oder Implantation dieser Art besteht in der Zusammensetzung und der Eindringtiefe des Beschichtungematerials. Die Eindringtiefe kann einige 1oonm erreichen und ermöglicht eine Schichtenbildung aus der Tiefe der Oberfläche. Die Eindringtiefe ist über die Beschleunigungsspannung steuerbar. Sie erlaubt, bei entsprechender Auslegung der erfindungsgemäßen Vorrichtung, eine Beschleunigung bis $\approx$ 350keV.

Die ECR-IQ hat z.B. einen Einsatzbereich, der die Anwendung als Ionenquelle für einfach und mehrfach geladene Moleküle und Ionen zur Einspeisung in Beschleuniger, der Ionisation eines polarisierten Ionenstrahles, Atometrahles, der Sterilisation von Implantaten und des Instrumentariums in der Medizin und Technik umfaßt. Besonders geeignet ist die erfindungsgemäße ECR-IQ zur Implantation radioaktiver Elemente in Oberflächen und tiefere Schichten einer Oberfläche. Der Implantation von Ionen und radioaktiven Ionen in erreichbare Bereiche des Humangewebes verlangt/erfordert neue Denkanstöße in der Onkologie.

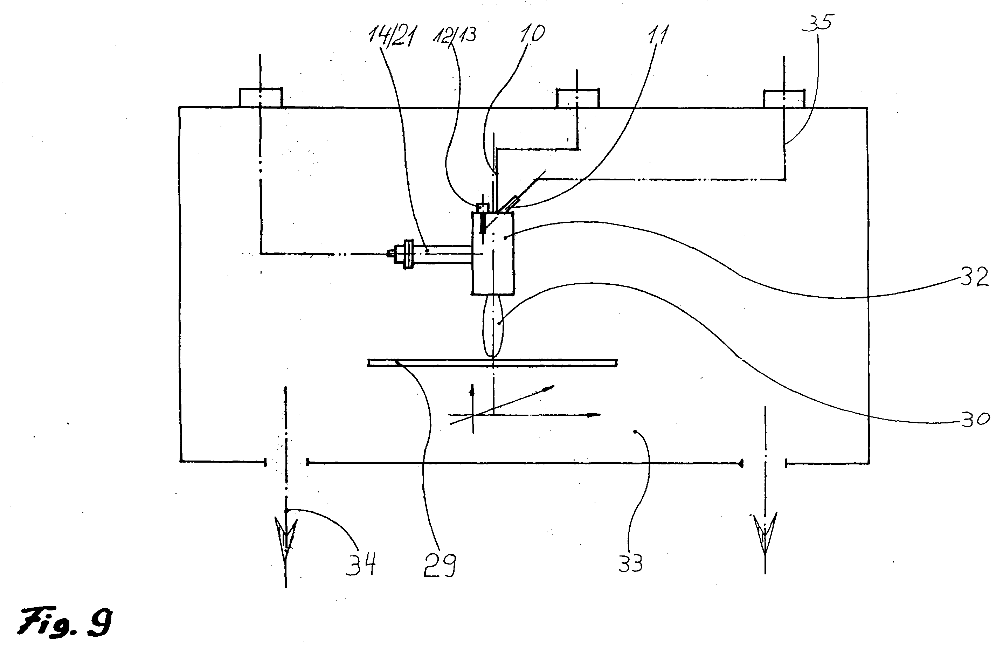

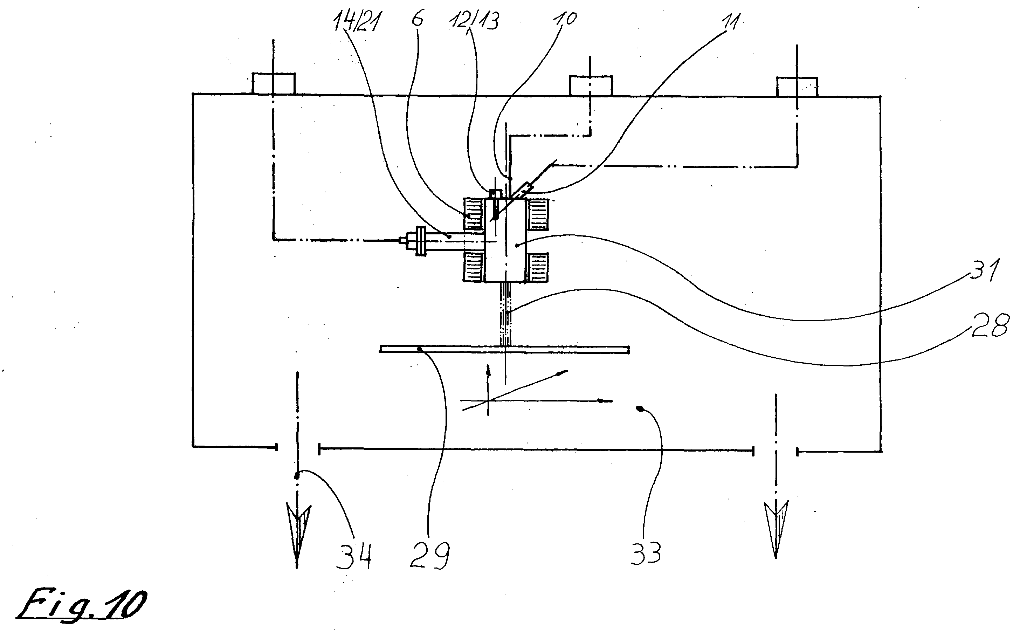

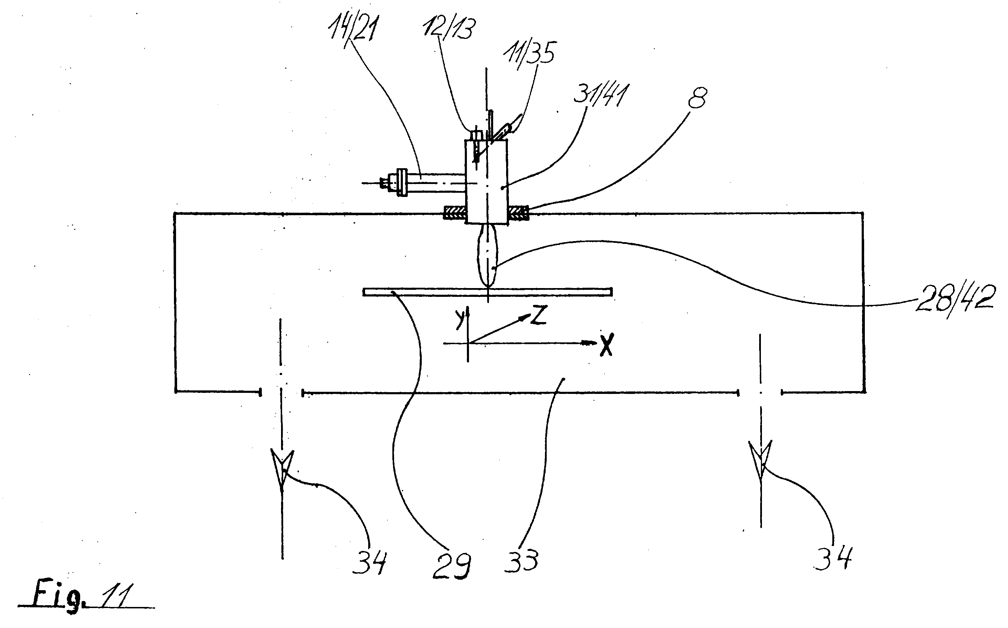

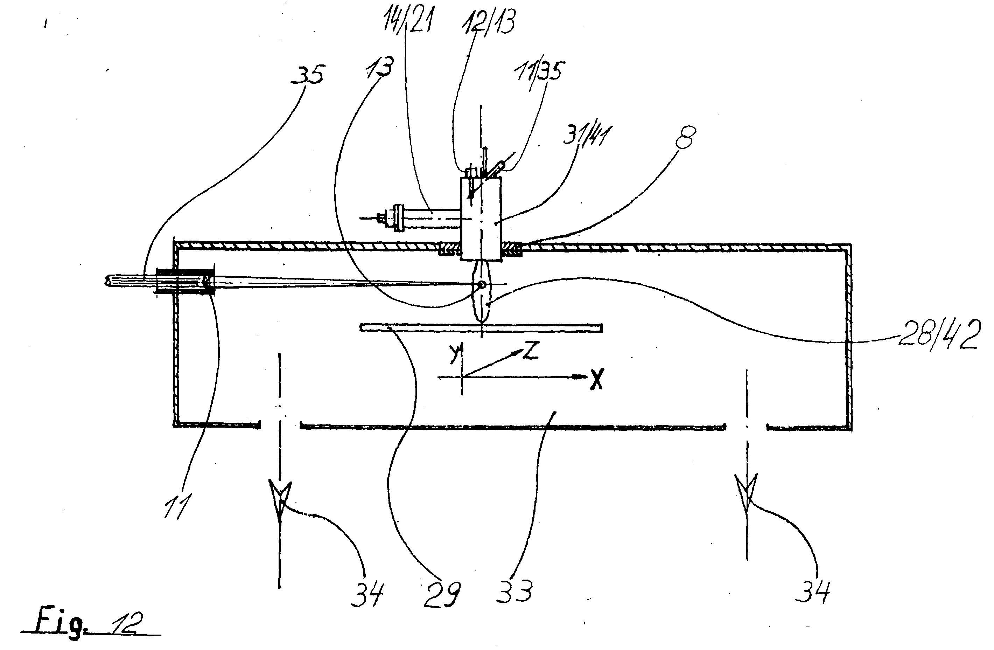

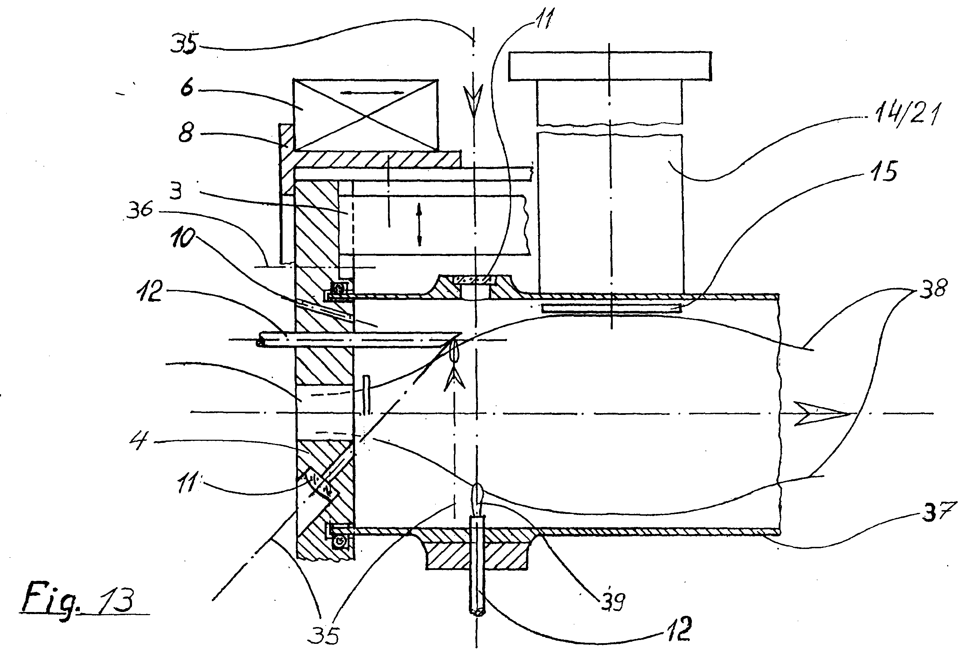

Eine besonders vorteilhafte Anwendung der erfindungsgemäßen ECR-IQ ist dadurch gegeben, daß unter Auslassung des magnetischen Längsfeldeinschlußes, nur mit dem magnetischen Querfeld des Multipol der Permanentmagnete, Fig. 9 u.11, ein ECR-Plasma erzeugt und in einer Plasmafackel extrahiert werden kann. Dies hat weitreichende Folgen in der Anwendung der Oberflächen-Mödifizierung/-Optimierung.

Eine vorteilhafte Anwendung/Ausgestaltung ist z.B. dadurch gegeben, daß die erfindungsgemäße ECR-IQ in einem Vakuumgefäß entsprechender Größe bewegbar installiert, das Plasma extrahiert, zur Oberflächen-Beschichtung, -Behandlung, -Optimierung einsetzbar ist, Fig. 9.

Ein weiterer Anwendungsbereich ist die Verwendung als Plasmatriebwerk zur Lagestabilisation von Sateliten im Orbit.

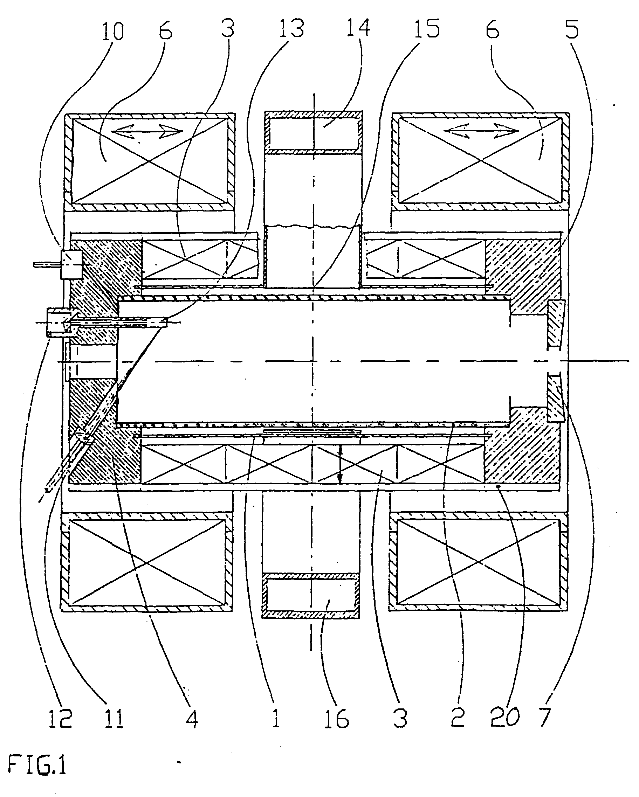

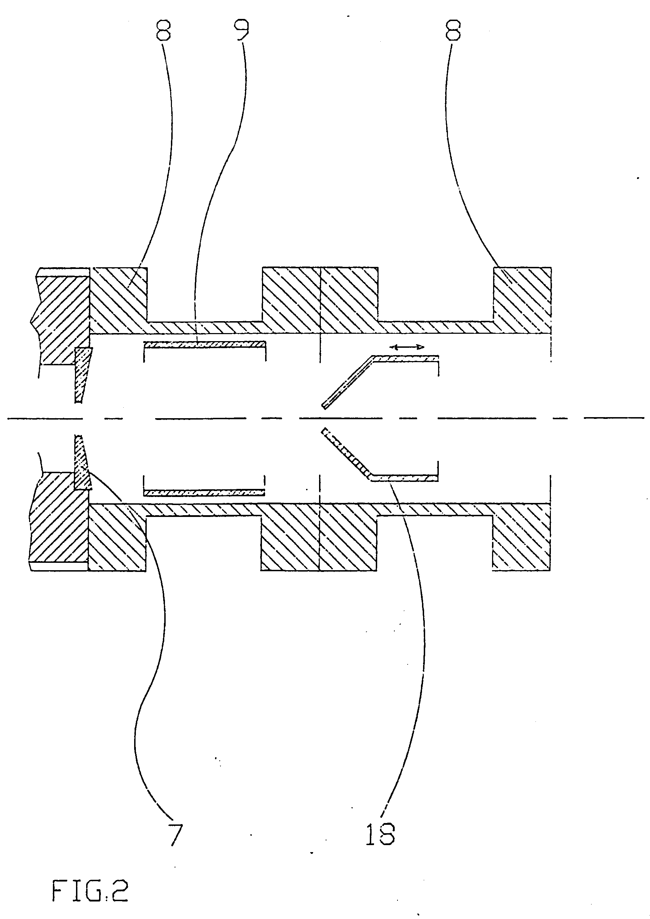

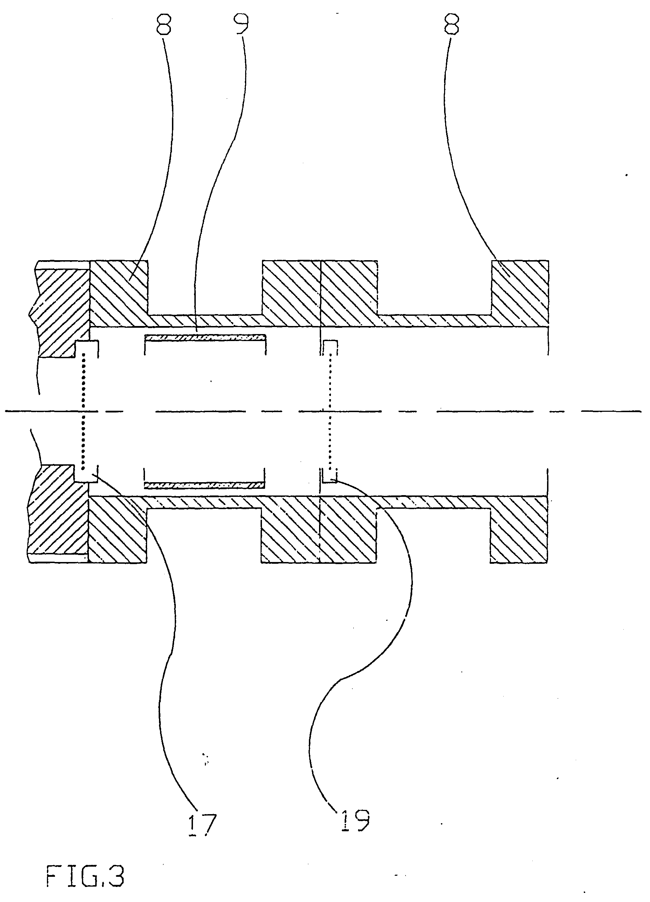

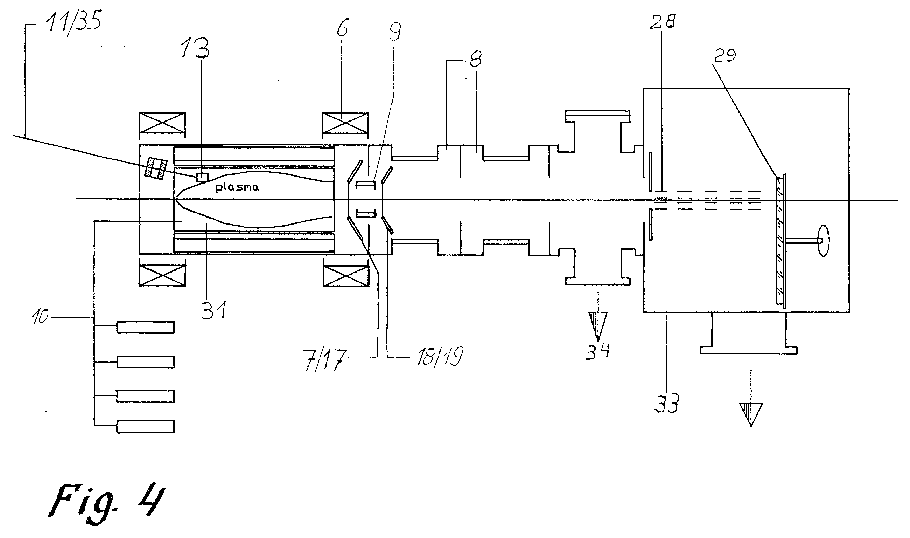

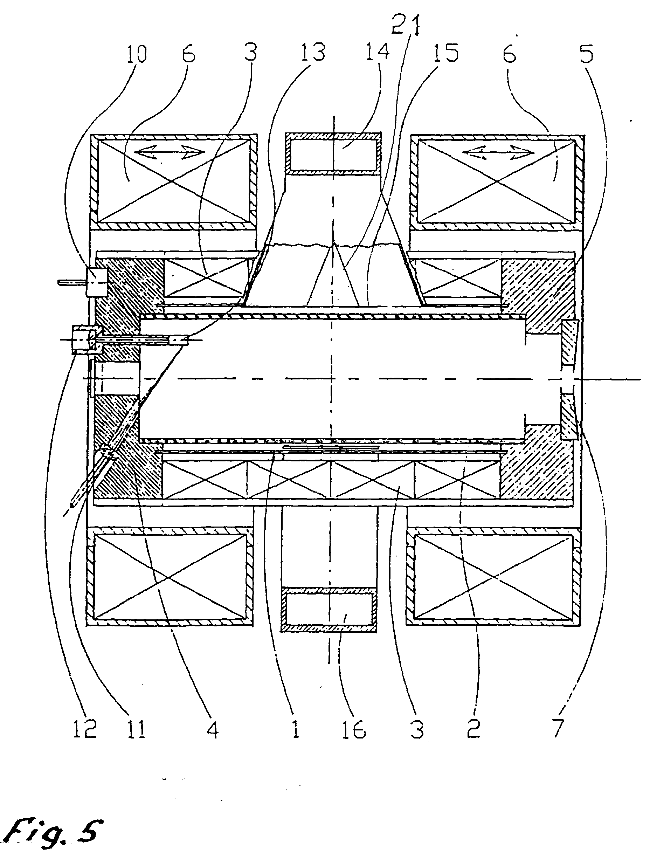

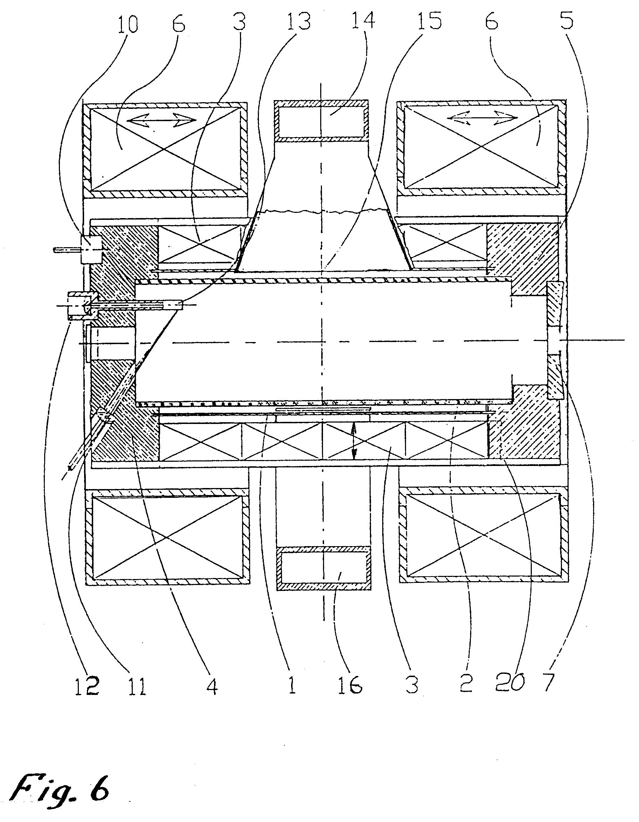

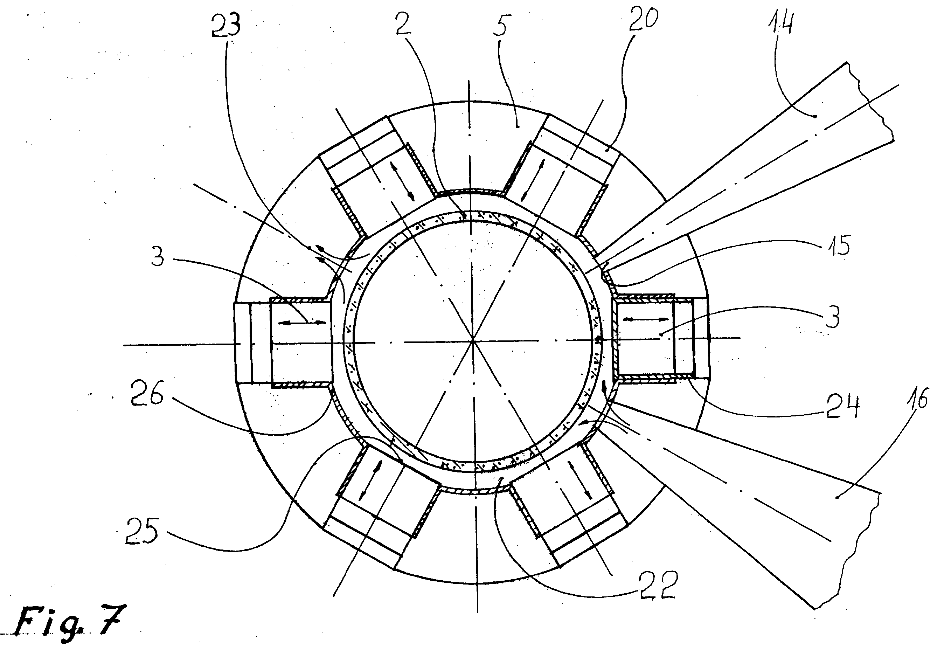

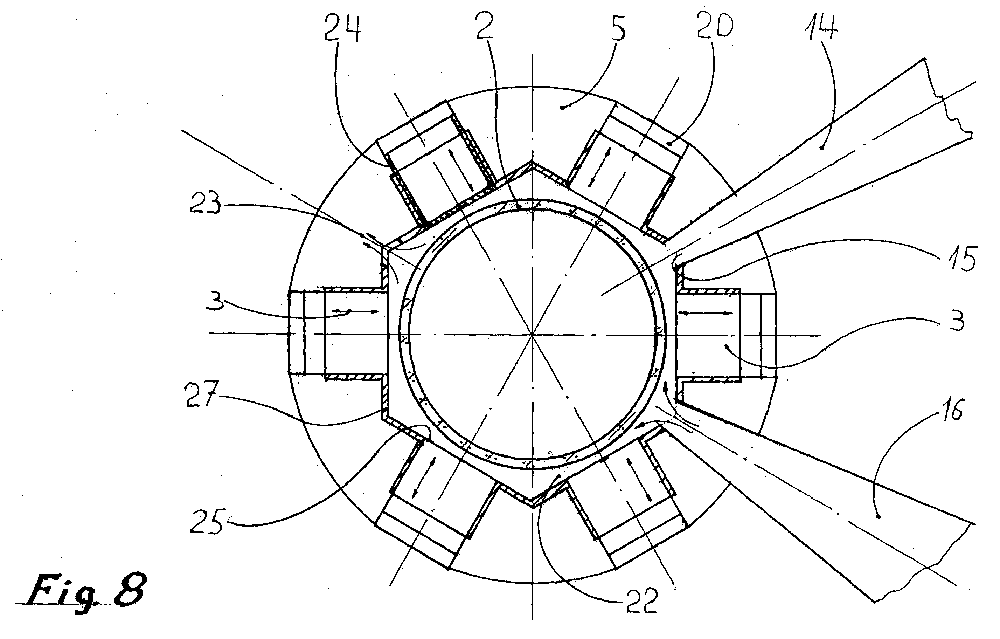

Eine vorteilhafte Ausführung der erfindungsgemäßen ECR-IQ zeigt Fig. 1.

Bezugsnummern u.Fig.-Zuordnung

| Bzg. Nr. | | Fig.-Zuordng. |
|---|---|---|
| 1 | cavity | 1,5,6,7,u.8 |
| 2 | Rohr | " |
| 3 | Permanentmagnete (6- od.Multipol) | " |
| 4 | Flansch | 1,5 u.6 |
| 5 | Flansch | 1,5,6,7u.8 |
| 6 | Ringmagnet Anordnung | 1,4,5,6,11 u.12 |
| 7 | Plasmaelektrode / -gitter | 1,2,3,4,5 u.6 |
| 8 | Isolator | 2,3,4,11u.12 |
| 9 | Hohlzylinder | 2,3u.4 |
| 10 | Gaseinlaß | 1,4,5,6,9,10,11 ,12 u.13 |
| 11 | Laserfenster/-Linsen / Laserstrahl | " |
| 12 | Targethalter | " |
| 13 | Target | " |
| 14 | Hohlleiter/μ-Wellen-Einspeisung / Modenkeil | 1,5,6,7u.8 |
| 15 | Einkoppelschlitz | " |
| 16 | Kühlgaszufuhr | " |
| 17 | Plasmagitter/Gitterelektrode | 3u.4 |
| 18 | Absaugelektrode | 2u.4 |
| 19 | Absauggitter/Gitterelektrode | 3u.4 |
| 20 | Verbindungsstrebe | 1,5,6,7u.8 |
| 21 | Modenkeil | 6 |
| 22 | Kühlgaskanal | 7u.8 |
| 23 | Kühlgasaustritt | " |
| 24 | Ummantelung Permanentmagnete 6-/Multipol | " |

Bezugsnummern u.Fig.Zuordnung

| Bzg. Nr. | | Fig.-Zuordng. |
|---|---|---|
| 25 | Ummantelung Bodenseite | 7u.8 |
| 26 | Segment Ersatz-cavity rund | 7 |
| 27 | " " " 6-Eck | 8 |
| 28 | Ionenstrahl | 4,10u.12 |
| 29 | Beschichtungsobjekt | 4,9,10,11u.12 |
| 30 | Plasmafackel | 9u.11 |
| 31 | ECR-IQ mit Ringmagnet-Anordnung | 1,4,5,6,9u.11 |
| 32 | " ohne " " | 1,4,5,6,10u12 |
| 33 | Prozesskammer | 4,9,10,11u.12 |
| 34 | Vakuumpumpen | " |
| 35 | Laserstrahl (hervorgehoben) | 4,9,10,12 u.13 |
| 36 | Trennlinie | 13 |
| 37 | Vakuum-cavity-Einheit | 13 |
| 38 | ECR-Plasma-Randzone | 4 u.13 |
| 39 | Laserablation | 13 |
| 40 | Zentralöffnung | 13 |
| 41 | ERC-IQ ohne Ringmagnet-Anordnung | 12 |
| 42 | ECR-Plasma extrahiert | 11 u.12 |

## Patentansprüche

**1.1** ECR-IQ, gemäß Fig. 1, die zentral und axial ausgerichtet, ein $\mu$-Wellentransparentes Rohr (2) besitzt, das in den Flanschen (4 u. 5) vakuumdicht gelagert ist.

**1.2** Eine zylindrische cavity (1), die den Vakuumeinschluß zentrisch umschließt. Die Dimensionen der cavity sind $\lambda$-abhängig.

**1.2.1** Ein Hohlleiter (14) mit definierter Formgebung zur Einspeisung der $\mu$-Wellen, trifft rechtwinkelig und zentral auf die cavity (1) und bildet einen Einkoppelschlitz (15). Die Angaben rechtwinkelig und zentral bedeuten keine Einschränkung bezüglich Winkel und Position.

**1.2.2** Die Kühlgaszufuhr (16) leitet einen Kühlgasstrom zwischen Rohr (2), des Vakuumeinschlusses und der cavity (1) zur Austrittsöffnung in der cavity (1).

**2.1** ECR-IQ, gemäß 1.1 bis 1.2.2, mit den Seitenflanschen (4 u. 5). Wobei der Flansch (4) wenigstens eine Gaszufuhr (10), wenigstens einen Targethalter (12) und wenigstens ein Target (13) besitzt.

**2.2** Flansch (4) besitzt wenigstens ein Laserfenster und/oder wenigstens eine Laserlinse.

**2.3** Flansch (5) ist mit der Plasmaelektrode (7) oder dem Plasmagitter (17) in der Strahlaustrittöffnung bestückt.

**2.4** Verbindungsstrebe (2o) ist stabiles Verbindungelement zwischen den Flanschen (4 u.5) und Träger für den radialen Magnetfeldeinschluß(3).

**3.1** ECR-IQ, gemäß 1.1 bis 2.4 mit dem Magnetfeldeinschlußsystem (3 u. 6), dadurch gekennzeichnet, daß der mit den Permanentmagneten ausgestattete Multipol (3) zusammen mit der ring-magnetischen Anordnung (6) einen magnetischen Plasmaeinschluß bilden. Weiter dadurch gekennzeichnet, daß beide Systeme (3 u. 6) axial und radial einstellbar sind.

**3.2** Weiter dadurch gekennzeichnet, daß die Permanentmagnete (3) des Multipoles (3) mit Cu oder Ag-Blech ummantelt sind. Diese Angaben bedeuten keine Einschränkung bezüglich der Materialien. (Ummantelung zeigt (3 u.24)), Fig.7 u.8.

**4.1** ECR-IQ, gemäß den Ansprüchen 1.1 bis 3.2,weiter dadurch gekennzeichnet, daß anschließend an Flansch (5) die Isolatoren, Fig. 2 (8), mit dem Hohlzylinder (9), der Absaugelektrode (18) und

**4.2** den Gitterelektroden, Fig. 3 (19 u. 17), folgen.

**4.2.1** Die Reihenfolge ist prozessabhängig.

**5.1** ECR-IQ, gemäß den Ansprüchen 1.1 bis 4.2, dadurch gekennzeichnet, daß die cavity (1), Rohr (2), Hohlleiter (14), Einkoppelschlitz (15), Targethalterbohrung (12) mit Targethalter (12) mit Target (13) und Laserfenster zu einer Einheit zusammengefaßt sind, Fig.13 (37).

**5.1.1** Es ist vorteilhaft, diese Einheit in Edelstahl herzustellen und die Innenseite z.B. mit Al zu beschichten, Fig.13.Die Einheit ist austauschbar.

**5.1.2** Die Materialangaben bedeuten keine Einechränkung bezüglich der Materialanwendung.

**6.1** ECR-IQ, gemäß den Ansprüchen 1.1 bis 5.1.2, dadurch gekennzeichnet, daß der Hohlleiter (14), Fig. 5, im Bereich des Einkoppelschlitzes (15), Fig. 5, in axialer Richtung zur cavity (1) einen Doppelschlitz bildet, durch den Modenkeil (21), Fig. 5, getrennt. Die Seitenwände

**zu 6.1** des Hohlleiters (14) im Bereich des Doppel-Einkoppelschlitzes ungleich 90° auf der cavity (1)aufsitzen.

**6.2** Anspruch gemäß 6.2, dadurch gekennzeichnet, daß der Modenkeil (21), Fig. 6, entfernt ist und in axialer Richtung zur cavity (1) einen Einkoppelschlitz (15), Fig. 6, bildet. Die Seitenwände des Hohlleiters (14) im Bereich des Einkoppelschlitzes (15), Fig. 6, ungleich 90° auf der cavity (1) aufsitzen.

**7.1** ECR-IQ, gemäß den Ansprüchen 1.1 bis 6.2, dadurch gekennzeichnet,daß die Ummantelung der Permanentmagnete des Multipoles gemäß Anspruch 3.3 u. 3.2 eine Ersatzcavity, Fig. 7, bilden, die cavity$\frac{segmente}{elemente}$ (26) Fig. 7 , mit der Ummantelung des Multipoles (24), Fig.7 galvanisch verbunden sind und bezüglich der μ-Welleneinspeisung und Gaskühlung alle Elemente der cavity (1),Fig. 1; Fig. 5 und Fig. 6, aufweisen.Zeigt auch (16,23u.25).

**7.2** Ansprüche gemäß 7.1 dadurch gekennzeichnet, daß die cavitysegmente (27), Fig.8 , der Ersatzcavity, Fig.8 , zusammen mit dem Multipol (3), Fig. 1, und (3),Fig.8 , ein Sechseck bilden.

**8.1** ECR-IQ, gemäß den Ansprüchen 1.1 bis 7.2, dadurch gekennzeichnet, daß mittels der erfindungsgemäßen Vorrichtung eine Legierung in der Plasmaphase der Materie erzeugt wird und mittels eines Ionenstrahles auf eine Oberfläche aufgetragen/implantiert wird.

FIG.1

FIG.2

FIG.3

11/35

13

6

9

8

28

29

plasma

31

10

7/17

18/19

34

33

**Fig. 4**

Fig. 5

Fig. 6

Fig. 7

EP 0 967 628 A2

Fig. 8

EP 0 967 628 A2

*Fig. 9*

14/21  12/13  10  11  35

32

30

34  29  33

EP 0 967 628 A2

14

Fig.10

14/21   12/13   11/35   31/41   8

28/42

y   Z   X

34   29   33   34

Fig. 11

EP 0 967 628 A2

16

Fig. 12

Fig. 13